# EUROPÄISCHE PATENTSCHRIFT

(11) **EP 1 153 155 B1**
(45) Veröffentlichungstag und Bekanntmachung des Hinweises auf die Patenterteilung: **19.01.2005**
(21) Anmeldenummer: 99957242.3
(22) Anmeldetag: 15.12.1999
(51) Int. Cl.: C23C 14/50, F16H 1/00

(54) **PLANETENSYSTEM-WERKSTÜCKTRÄGER UND VERFAHREN ZUR OBERFLÄCHENBEHANDLUNG VON WERKSTÜCKEN**
PLANETARY SYSTEM WORKPIECE SUPPORT AND METHOD FOR SURFACE TREATMENT OF WORKPIECES
PORTE-PIECES A SYSTEME PLANETAIRE ET PROCEDE DE TRAITEMENT DE SURFACE DE PIECES

(30) Priorität: 15.12.1998 CH 247798
(43) Veröffentlichungstag der Anmeldung: 14.11.2001
(73) Patentinhaber: BALZERS AKTIENGESELLSCHAFT, 9496 Balzers (LI)
(72) Erfinder: ZAECH, Martin, FL-9496 Balzers (LI); KUNZ, Anton, FL-9497 Triesenberg (LI)
(74) Vertreter: Troesch Scheidegger Werner AG
(86) Internationale Anmeldenummer: PCT/CH1999/000602
(87) Internationale Veröffentlichungsnummer: WO 2000/036178

(56) Entgegenhaltungen:
- US-A- 3 598 083
- US-A- 3 853 091
- PATENT ABSTRACTS OF JAPAN vol. 013, no. 383 (E-811), 24. August 1989 (1989-08-24) & JP 01 133320 A (TOSHIBA MACH CO LTD), 25. Mai 1989 (1989-05-25)
- PATENT ABSTRACTS OF JAPAN vol. 013, no. 383 (E-811), 24. August 1989 (1989-08-24) & JP 01 133318 A (TOSHIBA MACH CO LTD), 25. Mai 1989 (1989-05-25)
- PATENT ABSTRACTS OF JAPAN vol. 014, no. 106 (C-0694), 27. Februar 1990 (1990-02-27) & JP 01 309967 A (ISHIKAWAJIMA HARIMA HEAVY IND CO LTD), 14. Dezember 1989 (1989-12-14)

## Beschreibung

Die vorliegende Erfindung betrifft einen Vakuumbehandlungs-Planetensystem-Werkstückträger nach Anspruch 1 sowie ein Herstellungsverfahren für Werkstücke nach Anspruch 13.

Sie betrifft grundsätzlich die Werkstückträgertechnik für Vakuumbehandlungs-, insbesondere Vakuumbeschichtungsanlagen. Ziel der Werkstückträgertechnik ist es dabei immer, die Werkstücke so an Behandlungsquellen, wie insbesondere Beschichtungsquellen und Ätzquellen, vorbeizubewegen, dass eine möglichst gleichmässige Behandlungswirkung, insbesondere Beschichtungsdicke und - qualität, an allen zu behandelnden Flächen der Werkstücke sichergestellt wird.

In der nicht vorveröffentlichten Schweizer Patentanmeldung Nr. 2278/97 bzw. 1736/98 und der entsprechenden WO 99/16927, jeweils vom 25.9.97 bzw. 25.8.98, ist ein Planetensystem-Werkstückträger beschrieben, der wie folgt aufgebaut ist:

Es ist ein mit einem anlageseitigen Antrieb koppelbares, bezüglich Anlage um eine Achse drehbares, erstes System vorgesehen.

Dieses erste Drehsystem wird im folgenden als Sonnensystem bezeichnet.

Bezüglich des Sonnensystems ist an letzterem, mit Drehachse versetzt und parallel bezüglich derjenigen des Sonnensystems, ein zweites Drehsystem, im weiteren Planetensystem genannt, vorgesehen, dessen Drehbewegung durch lösbaren Eingriff auf das durch die Anlage bzw. Kammer gebildete Bezugssystem erstellt wird.

Am Planetensystem ist ein drittes Drehsystem, im weiteren Mondsystem genannt, vorgesehen, welches mit Drehachse parallel zur Planetensystem- und Sonnensystemachse drehgelagert ist. An den Mondsystemen werden die Werkstücke in Eigenrotation versetzt.

Werkstückträger dieser Art mit Dreifachdrehbewegung werden insbesondere bei relativ kleinen Werkstücken angewandt, um sie an anlagenfesten Behandlungsquellen, wie Beschichtungsquellen, vorbeizuführen und allseitig regelmässig zu behandeln.

An der vorbeschriebenen Werkstückträgeranordnung werden die Mondsysteme intermittierend in Drehbewegung versetzt. Dies, indem sie mit der Sonnensystemdrehbewegung und der überlagerten Planetendrehbewegung an Anschlägen vorbeigeführt werden, welche federartig ausgebildet auf eine rätschenartige Verzahnung an den Mondsystemen einwirken. Schwergängige Mondsysteme laufen dabei ohne Drehinkrementierung an den Anschlägen vorbei, was entsprechend negative Folgen auf die gleichförmige Werkstückbehandlung hat. Generell bedeutet die ruckartige inkrementale Drehbewegung der Mondsysteme, dass, vor allen bei relativ kurzen Behandlungszeiten, insbesondere Beschichtungszeiten der Werkzeuge und entsprechend vorgesehener geringer Behandlungswirkung bzw. geringer Schichtdicke, aufgrund von statistischen Schwankungen bezüglich der federnden Anschlagseingriffe und der daraus resultierenden Ausrichtung der Substrate zu Behandlungsquellen, negative Auswirkungen auf die Behandlungshomogenität an den Werkstücken resultiert.

Aus der US-A-3 853 091 ist ein Vakuumbehandlungs-Planetensystem-Werkstückträger bekannt mit einem um eine Sonnensystemachse drehbaren Sonnensystem, das mittels Reibrad-Eingriff angetrieben wird.

Das Sonnensystem ist durch einen zylindrischen Käfig gebildet, mit antriebsseitigem Abschluss und diesem gegenüberliegendem Abschluss. An letzterem sind Planetensysteme drehgelagert. Sie sind angetrieben durch Eingriff von Zahnrädern am antriebsseitigen Abschluss des Sonnensystems, die mit einem feststehenden Zahnkranz um diesen Abschluss in Wirkverbindung stehen, sowie jeweils diesen Antrieb zum gegenüberliegenden Abschluss übertragenden Antriebs-Stangen.

Am gegenüberliegenden Abschluss wird dieser Antrieb mittels Riemen an die Planeten übertragen. Bezüglich dieser Riemen unterhalb der Planeten sind daran scheibenförmige Monde drehgelagert. Die Monde sind über eine Verzahnungsverbindung mit den Planeten gekoppelt.

Es ist Aufgabe der vorliegenden Erfindung, den erwähnten Werkstückträger weiterzubilden und dabei die genannten Nachteile zu beheben. Dies wird an einem Planetensystem-Werkstückträger eingangs genannter Art durch dessen Ausbildung nach Anspruch 1 realisiert. Dadurch, dass die Antriebsverbindung zwischen Sonnensystem und Mondsystem ununterbrochen erstellt ist, wird eine kontinuierliche Mondsystem-Drehbewegung realisiert. Bevorzugterweise wird die Antriebsverbindung als Zwangsantriebsverbindung realisiert, so dass die Mondysteme zwingend in Drehbewegung versetzt werden.

Bevorzugte Ausführungsformen der erfindungsgemässen Werkstückträgeranordnung sind in den Ansprüche 2 bis 11 spezifiziert, ein erfindungsgemässes Herstellungsverfahren für Werkstücke in Anspruch 13.

Die Erfindung wird nachfolgend anhand von Figuren beispielsweise erläutert. Es zeigen:
- Fig. 1: schematisch, das Prinzip und die Funktionsweise einer ersten Ausführungsform eines erfindungsgemässen Werkstückträgers zur Durchführung des erfindungsgemässen Behandlungsverfahrens,
- Fig. 2: vereinfacht und in teilschematischer Ansicht, einen Ausschnitt an einer bevorzugten Realisationform des erfindungsgemässen Werkstückträgers, dem Funktions-prinzip gemäss Fig. 1 folgend,
- Fig. 3: den Eingriff einer Planetensystem-Partie auf eine Sonnensystem-Partie, wie bevorzugt bei der Ausführungsform gemäss den Fig. 1 und 2 realisiert,
- Fig. 4: in Darstellung analog zu derjenigen von Fig. 1, das Prinzip einer weiteren Ausführungsform eines erfindungsgemässen Werkstückträgers,
- Fig. 5: in Darstellung analog zu Fig. 2, einen Ausschnitt einer bevorzugten Realisationsform des erfindungsgemässen Werkstückträgers, realisiert dem Prinzip gemäss Fig. 4 folgend,
- Fig. 6: in Darstellung analog zu den Fig. 1 bzw. 4, eine dritte prinzipielle Realisationsvariante eines erfindungsgemässen Werkstückträgers,
- Fig. 7: in Darstellung analog zu den Fig. 2 bzw. 5, einen Ausschnitt einer bevorzugten Realisationsform erfindungsgemasser Werkstückträger, dem Prinzip nach Fig. 6 folgend,
- Fig. 8: in einer Darstellung analog zu den Fig. 1 bzw. 4 bzw. 6, das Prinzip einer weiteren Ausführungsform erfindungsgemässer Werkstückträger,
- Fig. 9: in Darstellung analog zu den Fig. 2, 5 bzw. 7, einen Ausschnitt einer bevorzugten Realisationsform erfindungsgemässer Werkstückträger, dem Prinzip nach Fig. 8 gehorchend,
- Fig. 10a: eine schematische Darstellung einer weiteren bevorzugten Antriebsverbindung zwischen Sonnen- und Planetensystem, und
- Fig. 10b: die Anordnung nach Fig. 10a, schematisch, in Aufsicht.

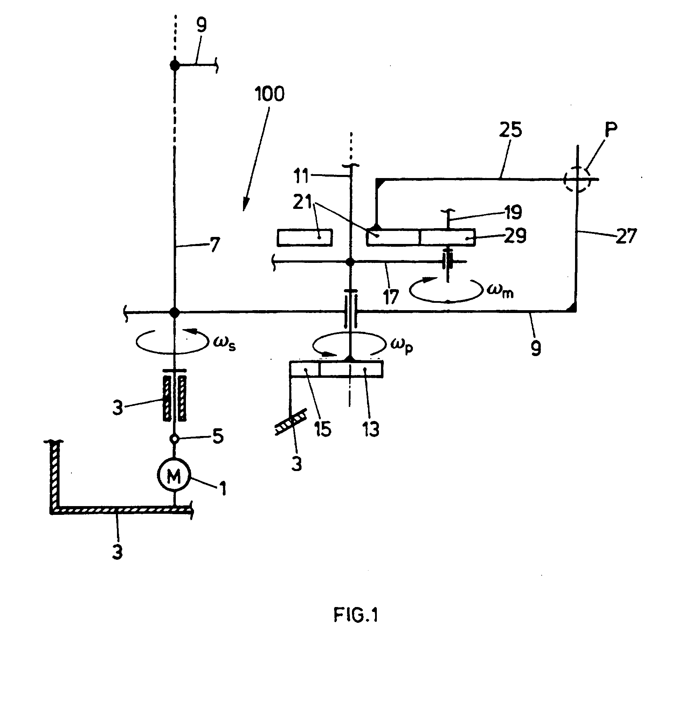

In Fig. 1 ist - aus Übersichtsgründen schematisch - eine erste Ausführungsvariante eines erfindungsgemässen Planetensystem-Werkstückträgers 100 dargestellt. Ein Drehantrieb 1 wirkt zwischen Kammerwand 3, als mechanisches Bezugssystem der Anordnung, und mindestens einem wie über eine Kupplung 5 lösbar mit dem Antrieb 1 antriebsgekoppelten erfindungsgemässen Werkstückträger 100. Dabei ist der Drehantrieb üblicherweise ausserhalb der Kammer mit der Kammerwand 3 angeordnet und mit einer vakuumdichten Drehdurchführung durchgeführt. Der Werkstückträger 100 weist eine Sonnensystemachse 7 auf, am mechanischen Bezugssystem 3 drehgelagert. Diese führt, getrieben, die Sonnendrehbewegung ωₛ aus. Am drehfest mit der Sonnensystemachse 7 verbundenen mindestens einen Sonnenrad 9 ist ein oder sind mehrere Planetenachsen 11 parallel zur Sonnensystemachse 7 drehgelagert. Sie stehen über ein Planetenantriebsrad 13, vorzugsweise über ein Zahnrad kämmend, mit einem bezüglich des mechanischen Bezugssystems 3 festen Übertragerring 15 in Eingriff, welcher Ring 15 koaxial zur Sonnensystemachse 7 angeordnet ist.

Bei Drehantrieb des Sonnensystems um die Sonnensystemachse 7 erfährt die Planetenachse 11 die Planetendrehung ωₚ.

An der mindestens einen Planetenachse 11 ist mindestens ein Planetenrad 17 drehfest angeordnet, woran, parallel zur Planetenachse 11, mindestens eine Mondachse 19 drehgelagert ist. Bezüglich der Planetenachse 11 frei drehbeweglich ist, hierzu koaxial, ein Übertragerrad 21, vorzugsweise Übertragerzahnrad, vorgesehen, welches mit einem an der Mondachse 19 drehfesten Mondantriebsrad 29, vorzugsweise als Zahnrad ausgebildet, in Eingriff steht.

Am Übertragerzahnrad 21 ist ein Anschlagbügel 25 befestigt, welcher, bei seiner Schwenkbewegung um die Planetenachse 11, schliesslich mit einem Anschlag 27 am Sonnensystem mit Sonnenrad 9, bei P, in Anschlagsverbindung kommt.

Bei Planetendrehung ωₚ und entsprechender Drehung der Mondachse 19 um die Planetenachse 11, kommt der Anschlagbügel 25 am Anschlag 27 zum Stillstand, worauf das Mondantriebsrad 29 in Rotation versetzt wird. Das Mondsystem dreht - ωₘ -, solange der Antrieb des Sonnensystems erstellt ist, ununterbrochen.

Am Mondsystem ist ein Werkstückhalter für mindestens ein in der Kammer zu behandelndes Werkstück vorgesehen.

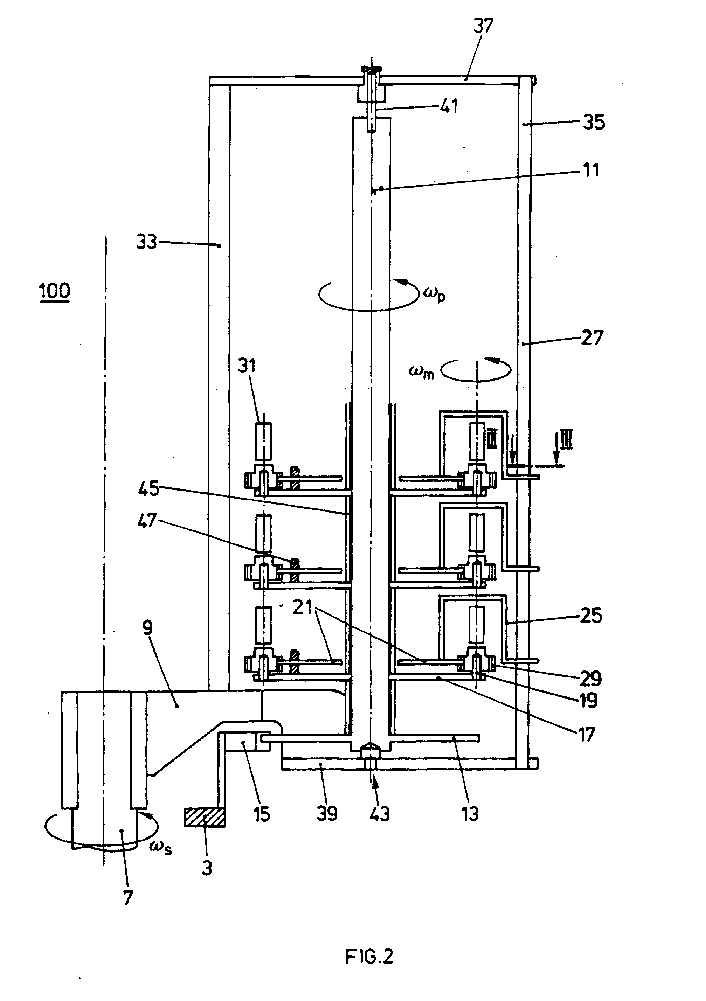

In Fig. 2 ist eine Realisationsform des prinzipiell anhand von Fig. 1 erläuterten erfindungsgemässen Planetensystem-Werkstückträgers dargestellt. Für bereits anhand von Fig. 1 erläuterte Teile werden die gleichen Bezugszeichen verwendet. Die Funktionsweise der bevorzugt wie in Fig. 2 realisierten Anordnung nach Fig. 1 ergibt sich ohne weiteres aus den Erläuterungen zu Fig. 1.

Dabei gilt zusätzlich: Werkstückhalter 31 sind an den Mondachsen 19 befestigt. Das Sonnensystem ist als Käfig aufgebaut, mit dem Sonnenrad 9, Längsstäben 33 und 35 sowie Speichen 37 und 39. Es ist ersichtlich, dass die äusseren Längsstäbe 35 gleichzeitig, gemäss Fig. 1, als Anschlag 27 wirken. Die Planetenachsen 11 sind, wie bei 41 dargestellt, oben an Stiftlagern gelagert, was ein leichtes Entfernen bzw. Wiedereinfügen des jeweiligen Planetensystems mit den Mondsystemen ermöglicht. Hierzu sind die Planetenachsen 11 unten bevorzugterweise und wie bei 43 dargestellt kegelgelagert.

Die drehfest an der Planetenachse 11 gelagerten und bevorzugterweise axial auf diese aufschiebbaren Planetenräder 17 werden durch Distanzhülsen 45 auf Abstand gehalten, welche ebenfalls über die Planetenachse 11 aufschiebbar sind. Die Führung der Übertragerzahnräder 21 kann, bei entsprechend enger Bemessung ihrer Zentrumsöffnung, an den jeweiligen Distanzhülsen 45 erfolgen. Die Übertragerzahnräder 21 können bei drei und mehr zugeordneten Mondsystemen durch deren Mondantriebsräder 29 geführt sein, was ermöglicht, die Zentrurnsöffnung der Übertragerzahnräder 21 material- und gewichtssparend gross auszubilden, und was weiter eine geringere Lagerreibung ergibt.

Sollen die Räder 21 mondsystemgeführt werden, so werden bevorzugt am jeweiligen Planetenrad 17 mindestens fünf Mondsysteme vorgesehen. Im weiteren können gegebenenfalls Stützräder 47 oder Gleitstützen (nicht dargestellt) an den Übertragerzahnrädern 21 und/oder Planetenrädern 17 vorgesehen sein, um die Übertragerräder zu führen.

Eine weitere Konstruktionsvariante besteht darin, die Planetenräder 17 drehfest mit den Distanzhülsen 45 zu verbinden und letztere als Lagerbüchsen für die genannten übertragerräder 21 einzusetzen.

Bei der Ausführungsform gemäss Fig. 1 bzw. Fig. 2 ergibt sich, dass bei Einsetzen der Sonnendrehbewegung ωₛ die Mondsysteme erst dann in Eigendrehung ωₘ versetzt werden, wenn die Planetendrehbewegung ωₚ die jeweiligen Anschlagbügel 25 an den Anschlägen bzw. Längsstäben 27 bzw. 35 in Anschlag gebracht hat.

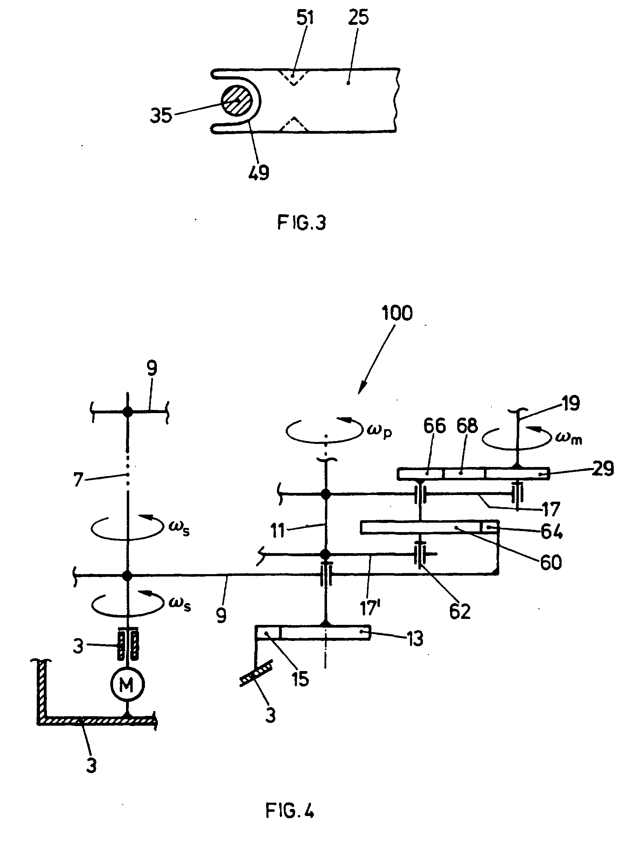

In Fig. 3 ist, gemäss Linie III-III von Fig. 2 geschnitten, ein Längsstab 35 dargestellt und die bevorzugte Ausformung des Anschlagbügels 25 in seinem Endbereich. Mit einer U-förmigen Einformung 49 ist der Bügel 25 schwenkfest an dem als Anschlag 27 wirkenden Längsstab 35 gelagert, womit verzugslos bei Einsetzen der Sonnendrehbewegung ωₛ auch die Monddrehbewegung ωₘ einsetzt.

Die Ausformung der Anschlagbügel 25 wird den unterschiedlichen Werkstück-Formen und -Grössen bzw. der Mondsystemauslegung angepasst.

Wie aus Fig. 2 erkenntlich, können bevorzugterweise am Sonnensystem wahlweise mehrere Planetensystem mit ihren Achsen 11 vorgesehen werden, an den Planetensystemen jeweils wahlweise mehrere Planetenräder 17 und an letzteren wahlweise jeweils mehrere Mondsysteme, weiter an einem Antrieb 1 bzw. in einer Kammer gemäss 3 mehrere Werkstückträger 100.

Um bei einem eventuellen Blockieren einer Mondbewegung oder einer Planetenbewegung zu verhindern, dass der gesamte erfindungsgemässe Werkstückträger verklemmt wird, können am erfindungsgemässen Werkstückträger Sollbruchstellen 51 eingebaut werden, um damit den Schaden auf einen möglichst kleinen Teil der jeweiligen Charge zu begrenzen. Bevorzugterweise können solche Sollbruchstellen, bei der Ausführungsform gemäss den Fig. 1 bis 3, an den Endpartien der Anschlagsbügel 25 vorgesehen sein. Durch einfache Überprüfung der jeweiligen Anschlagbügel 25 kann nachmals festgestellt werden, ob alle Mondsysteme ordnungsgemäss bewegt wurden. Hierzu können die an Sollbruchstellen 51 abbrechenden Endbereiche der Anschlagsbügel 25 optisch auffällig gekennzeichnet, z.B. bemalt, werden. Es können z.B. dort auch optoelektronische, kapazitiv oder induktiv bzw. magnetisch detektierbare Partien vorgesehen sein, um im Betrieb die Drehbewegungen in der Kammer 3 zu überwachen.

Eine weitere Kontrollmöglichkeit für ordnungsgemässes Funktionieren der erfindungsgemässen Werkstückträger ergibt sich durch Messung der am Antriebsmotor 1 aufgenommenen Leistung. Wird einer der am Antriebsmotor 1 gemäss Fig. 1 angekoppelten erfindungsgemässen Werkstückträger 100 blockiert, so steigt mit zunehmendem Lastmoment die aufgenommene Motorenleistung. Damit kann ein Alarmsignal und/oder eine automatische Abschaltung ausgelöst werden. Auf diese Weise ist es möglich, im Schadensfall, die Chargenbearbeitung frühzeitig zu unterbrechen, die erkannte Störung zu beheben und anschliessend den Bearbeitungsprozess dort fortzusetzen, wo er unterbrochen wurde.

In Fig. 4 ist, in Darstellung analog zu derjenigen von Fig. 1, schematisch eine weitere Ausführungsvariante eines erfindungsgemässen Werkstückträgers 100 dargestellt. Es sind dieselben Bezugszeichen wie in Fig. 1 für Teile eingesetzt, die auch bei der Ausführungsform gemäss Fig. 4 vorgesehen sind.

Es fallen Bügel 25 mit Übertragerrad 21 sowie Anschlag 27 gemäss Fig. 1 weg. An deren statt ist an einem Hilfsplanetenrad 17', pro Mondsystem und mit zur Planetenachse 11 paralleler Drehachse 62, ein Übertragerrad 60, vorzugsweise wiederum ein Zahnrad, drehgelagert. Das Rad 60 steht mit einer koaxial um die Planetenachse 11 umlaufenden (nicht dargestellt) Übertragerfläche 64 - als Zahnrad 60 ausgebildet mit einem Zahnkranz kämmend - in Eingriff. Ein weiteres, an der Drehachse 62 drehfestes Übertragerrad 66, vorzugsweise ein Zahnrad, steht in Eingriff mit einem koaxial um die Planetenachse 11 umlaufenden Übertragerring 68, vorzugsweise ausgebildet als innen- und aussenverzahnter Ring. Mit der Innenfläche des Ringes 68 steht das Übertragerrad 66 in Eingriff, mit der Aussenfläche das Mondantriebsrades 29. Der Übertragerring 68 ist am Planetenrad 17 gleitgelagert. Durch entsprechende Bemessung insbesondere der Übertragerräder 66 und des Übertragerringes 68 kann die Mondumlaufgeschwindigkeit den Bedürfnissen entsprechend angepasst werden. Somit kann die Monddrehbewegung ωₘ beispielsweise so langsam eingestellt werden, dass zwar die daran vorgesehenen Werkstücke noch gleichmässig und allseitig behandelt, insbesondere beschichtet, werden, gleichzeitig aber die Mondsystemdrehlager einem minimalen Verschleiss ausgesetzt sind.

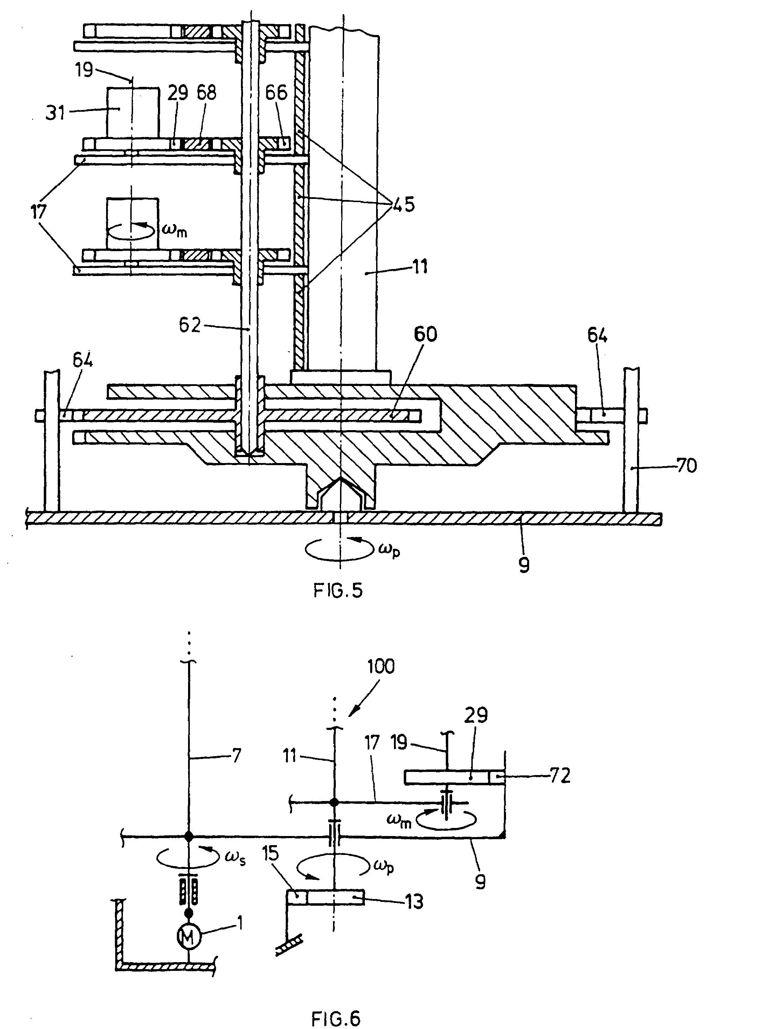

In Fig. 5 ist eine Realisationsform der schematisch anhand von Fig. 4 dargestellten Variante eines erfindungsgemässen Planetensystem-Werkstückträgers dargestellt. Weiterhin werden für bereits vorbeschriebene Teile dieselben Bezugszeichen verwendet. Ohne weiteres ergibt sich insbesondere aufgrund der Verwendung derselben Bezugszeichen der Aufbau der erfindungsgemässen Werkstückträger nach Fig. 5 aus den Erläuterung zu Fig. 4.

Zudem ist ersichtlich: Die Übertragerfläche 64 gemäss Fig. 4 ist als innenverzahnter Ring an Halteankern 70 montiert, welch letztere am Sonnenrad 9 fixiert sind.

Dem bisher gewählten Vorgehen folgend, ist in Fig. 6, analog zu den Fig. 1 bzw. 4, wiederum schematisch, das Prinzip einer weiteren Ausführungsvariante des erfindungsgemässen Werkstückträgers 100 dargestellt. Es wird Bezug genommen auf die Ausführungsvariante gemäss Fig. 1 bzw. Fig. 2. Bei der Ausführungsform gemäss Fig. 6 entfallen, mit Blick auf Fig. 1, wiederum Übertragerrad 21, Anschlagbügel 25 und Anschlag 27. An deren statt ist am Sonnenrad 9 eine umlaufende Übertragerfläche 72 vorgesehen, vorzugsweise in Form eines koaxialen um die Planetenachse 11 umlaufenden (in Fig. 6 nicht dargestellt) innenverzahnten Ringes. Das Mondantriebsrad steht mit der Übertragerfläche 72 in Antriebsverbindung. Sofern das Mondantriebsrad 29 ein aussenverzahntes Zahnrad ist, kämmt es mit der die Übertragerfläche 72 bildenden Verzahnung des koaxial um die Planetenachse 11 angeordneten Ringes am Sonnenrad 9.

Auch hier kann durch entsprechende Dimensionierung der Monantriebsräder 29 und der Übertragerfläche 72, insbesondere deren gegenseitige Verzahnung, das Übersetzungsverhältnis in begrenztem Rahmen verstellt werden.

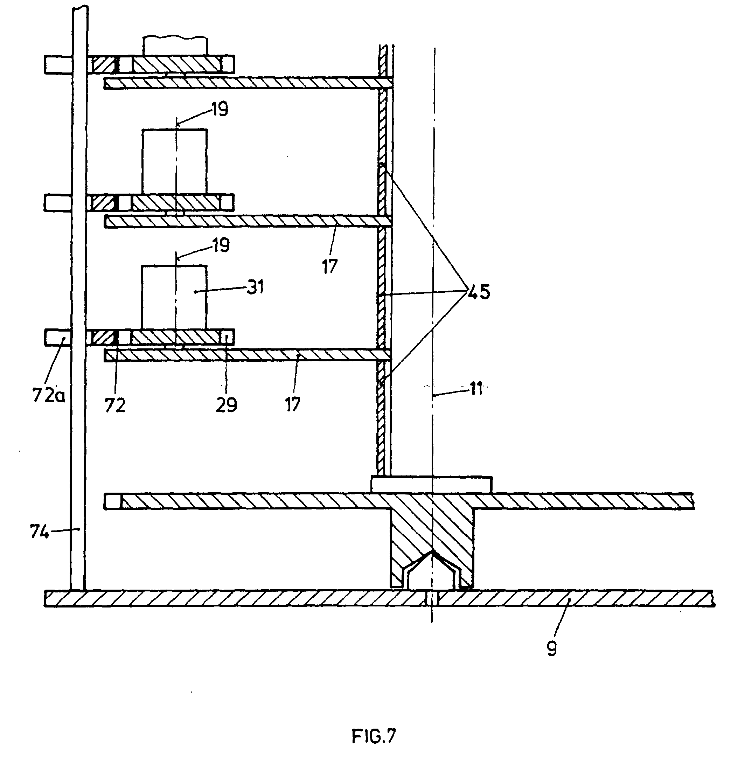

In Analogie zu den Fig. 2 und 5 ist in Fig. 7 ein bevorzugte Ausführungsform der erfindungsgemässen Werkstückträgervariante gemäss Fig. 6 dargestellt. Daraus ist ersichtlich, dass die Übertragerfläche 72, in Form der Innenverzahnung eines Zahnringes 72a, jeweils auf der Höhe der Umlaufbahn der Mondantriebsräder 29, mittels Halteankern 74 am Sonnenrad 9 gelagert sind.

Dabei können die Ringe 72a, auf den Halteankern 74, mit (nicht dargestellten) Abstandshaltebüchsen auf Abstand gehalten, auf diese Anker aufgesteckt werden. Damit ist eine rasche Ringmontage in den einzelnen Mondbewegungsebenen möglich.

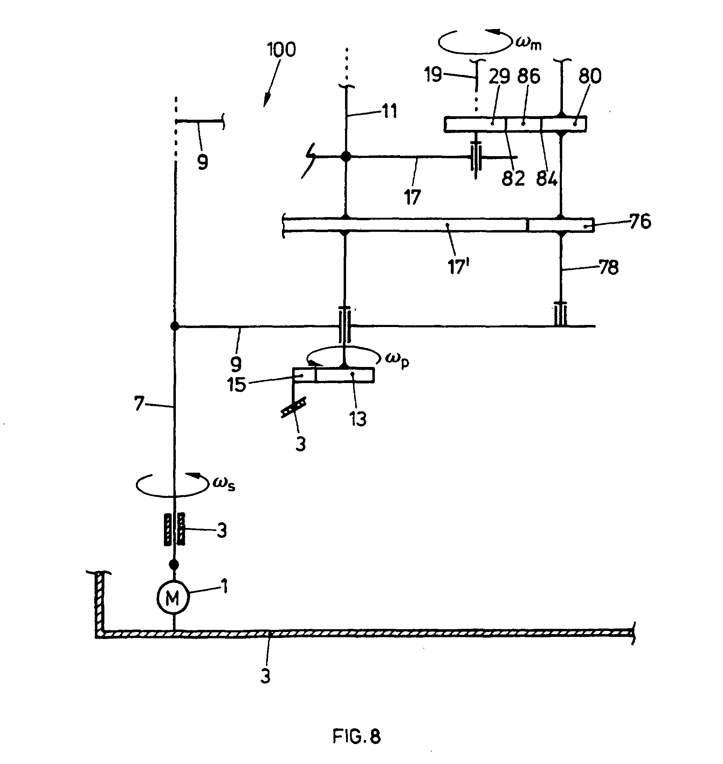

In Fig. 8 ist, wiederum analog zum bisherigen Vorgehen, schematisch das Prinzip einer weiteren Ausführungsvariante eines erfindungsgemässen Planetensystem-Werkstückträgers dargestellt. Es sind weiterhin dieselben Bezugszeichen für selbe Teile eingesetzt. Mit Bezug auf Fig. 1 fallen bei der Ausführungsform nach Fig. 8 wiederum Übertragerrad 21, Anschlagbügel 25 und Anschlag 27 weg. An deren statt ist drehfest an der Planetenachse 11 ein Hilfsplanetenrad 17', vorzugsweise in Form eines Zahnrades, vorgesehen, welches mit einem Übertragerrad 76, vorzugsweise wiederum einem Zahnrad, in Eingriff steht bzw. kämmt. Dies treibt eine am Sonnenrad 9 lösbar drehgelagerte, zur Sonnenachse 7 parallele Übertragerachse 78, welche auf der Höhe der jeweiligen Mondantriebsräder 29 jeweils ein abtriebsseitiges Übertragerrad 80, wiederum vorzugsweise in Form eines Zahnrades, trägt. Übertragerrad 80 einerseits und Mondantriebsrad 29 anderseits stehen je mit Innen- bzw. Aussenübertragerflächen 82/84 eines Übertragerringes 86 in Eingriff, vorzugsweise in Verzahnungsreingriff. Der Ring 82 ist (in Fig. 8 aus Übersichtsgründen beabstandet dargestellt) am jeweiligen Planetenrad 17 geführt und erstreckt sich koaxial um die Planetenachse 11. Wiederum kann durch entsprechende Dimensionierung der verschiedenen Übertrager, nämlich 17', 76, 80, 82 und 84 an 86, das Übersetzungsverhältnis zwischen Sonnensystem-Drehbewegung ωₛ und Mondsystem-Drehbewegung ωₘ eingestellt werden. Dabei können die Übertragerräder 80 sowie ggf. der übertragerring 82 bei Chargiervorgängen leicht ausgewechselt werden. Die Übertragerräder 80 können drehfest auf die Übertragerachse 78 aufgeschoben werden, wobei zwischen einzelnen Übertragerrädern 80 jeweils Distanzhülsen über die Übertragerachse 78 geschoben werden.

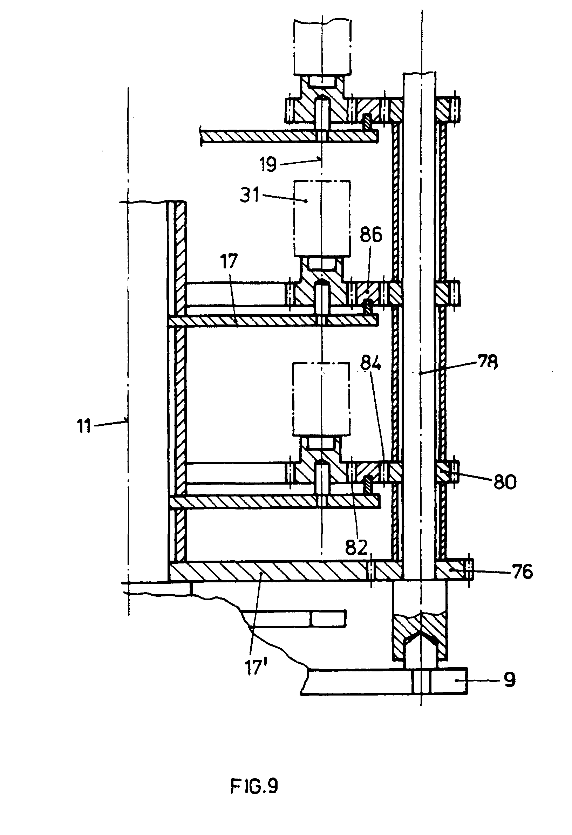

In Fig. 9 ist, in Analogie zu den Fig. 2, 5 und 7, eine bevorzugte Realisationsform der anhand von Fig. 8 schematisch erläuterten Ausführungsvariante des erfindungsgemässen Werkstückträgers dargestellt. Bei Wahl der bisher verwendeten Bezugszeichen und derjenigen, welche anhand von Fig. 8 eingeführt worden sind, ergibt sich für den Fachmann der Aufbau und die Funktionsweise der in Fig. 9 dargestellten Ausführungsform ohne weiteres.

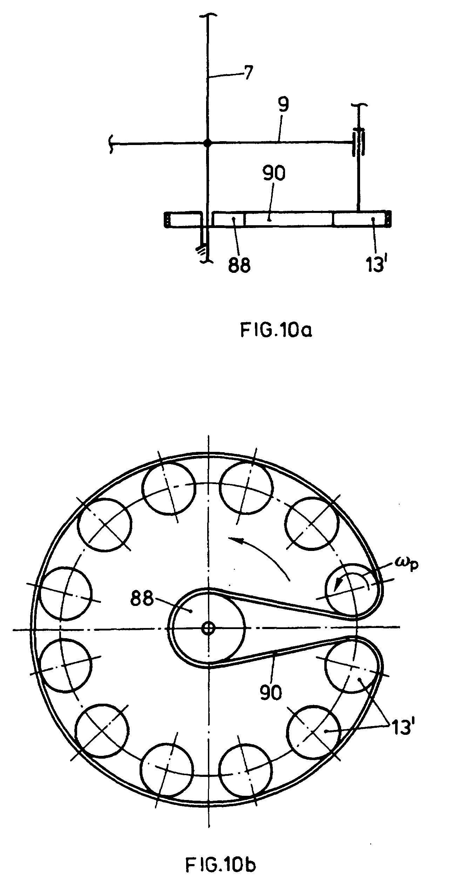

In Fig. 10 ist eine besonders einfache und damit bevorzugte Ausführungsvariante der Antriebsverbindung zwischen Sonnensystem und Planetensystem, so beispielsweise gemäss Fig. 1 zwischen den Sonnenachse 7 und dem Planetenrad 17 wirkend, dargestellt. Diese Anordnung kann mit allen beschriebenen weiteren Vorkehrungen zum Drehantrieb der Mondsysteme kombiniert werden, kann aber auch bei Systemen eingesetzt werden, bei denen lediglich ein Sonnen/Planetensystem realisiert ist, d.h. kein drehendes Mondsystem.

Gemäss Fig. 10a, weiterhin die bereits eingeführten Bezugszeichen verwendend, ist an der Sonnenachse 7, wie erläutert wurde von einem hier nicht dargestellten, ausserhalb der Vakuumkammer angeordneten Antrieb 1 getrieben, das Sonnenrad 9 gelagert. Es trägt, seinerseits daran drehgelagert, das Planetenrad 17, gemäss Fig. 1 (hier nicht nochmals dargestellt) sowie ein Planetenantriebsrad 13'. Die Sonnenachse 7 läuft zentral durch ein feststehendes Antriebsrad 88. Wie sich insbesondere aus der schematischen Aufsicht aus Fig. 10b entnehmen lässt, läuft ein Antriebsriemenelement 90 um das zentrale, feststehende Antriebsrad 88 sowie um die vorgesehenen Planetenantriebsräder 13' um. Die Rotationsgeschwindigkeit ωₚ der Planetenräder ist dabei über das Durchmesserverhältnis von Sonnenrad 9 und Planetenantriebsrad 13' in weiten Bereichen frei wählbar bzw. einstellbar. Die Planetenräder 13' rollen bei dieser Anordnung am Antriebsriemenelement 90 ab.

Mit Hilfe der erfindungsgemässen Planetensystem-Werkstückträger wird eine kontinuierliche Drehbewegung der Möndsysteme sichergestellt, was insbesondere auch bei kurzen Behandlungszeiten an den Mondsystemen abgelegter Werkstücke in einer Vakuumbehandlungsanlage, insbesondere in einer Beschichtungsanlage, zu einer regelmässigen, allseitig gleichmässigen Behandlung führt.

### Bezugszeichenliste

- 1: Drehantrieb
- 3: Wand, Bezugssystem
- 5: Kupplung
- 7: Sonnensystemachse
- 9: Sonnenrad
- 11: Planetenachse
- 13: Planetenantriebsrad
- 13': Planetenantriebsrad
- 15: Übertragerring
- 17: Planetenrad
- 17': Hilfsplanetenrad
- 19: Mondachse
- 21: Übertragerrad
- 23: Übertragerrad
- 25: Anschlagbügel
- 27: Anschlag
- 29: Mondantriebsrad
- 31: Werkstückhalter
- 33: Längsstäbe
- 35: Längsstäbe
- 37: Speichen
- 39: Speichen
- 41: Stiftlager
- 43: Kegellager
- 45: Distanzhülsen
- 47: Stützräder
- 49: Einformung
- 51: Sollbruch
- 60: Übertragerrad
- 62: Drehachse
- 64: Übertragerfläche
- 66: Übertragerrad
- 68: Übertragerring
- 70: Halteanker
- 72: Übertragerfläche
- 72a: Übertragerfläche
- 74: Halteanker
- 76: Übertragerrad
- 78: Übertragerachse
- 80: Übertragerrad
- 82/84: Übertragerflächen
- 86: Übertragerringe
- 88: Antriebsrad
- 90: Antriebsriemenelement
- 100: Werkstückträger

## Patentansprüche

1. Vakuumbehandlungs-Planetensystem-Werkstückträger für Vakuumbehandlungsanlagen, umfassend:
• ein mit einem anlageseitigen Antrieb (1) koppelbares, bezüglich Anlage um eine Sonnensystemachse (7) drehbares Sonnensystem (9, 9'),
• mindestens ein am Sonnensystem (9, 9') um eine Planetenachse (11) drehgelagertes und mit einer Antriebskopplung (15, 13) bezüglich der-Anlage (3) versehenes Planetensystem (17, 17')
• mindestens ein am Planetensystem (17) um eine Mondachse (19) drehgelagertes Mondsystem (29, 31) mit einer Antriebsverbindung zum Sonnensystem (7, 9, 9'), an welchem Mondsystem eine Aufnahme für mindestens ein Werkstück vorgesehen ist, wobei die Antriebsverbindung mindestens im Betrieb ununterbrochen zwischen Sonnensystem und Mondsystem erstellt ist.

2. Träger nach Anspruch 1, **dadurch gekennzeichnet, dass** die Antriebsverbindung eine Zwangsantriebsverbindung ist, vorzugsweise eine Verzahnungsverbindung.

3. Träger nach Anspruch 1 oder 2, **dadurch gekennzeichnet, dass** die Antriebsverbindung zwischen Mondsystem und Sonnensystem eine um die Planetenachse (11) frei drehbare, einerseits mit dem Sonnensystem (27), anderseits mit dem Mondsystem (29) in Übertragungseingriff stehende Übertrageranordnung (21; 60, 66, 68; 76, 80, 86) umfasst.

4. Träger nach Anspruch 1 oder 2, **dadurch gekennzeichnet, dass** die Antriebsverbindung ein um die Planetenachse (11) frei drehbares, mit einem Übertragerrad (29) am Mondsystem in Eingriff stehendes Übertragerrad (21) aufweist, welches mit einer Dreharretierung (25) auf einen Anschlag am Sonnensystem (9) wirkt.

5. Träger nach Anspruch 1, **dadurch gekennzeichnet, dass** die Antriebsübertragung eine koaxial zur Sonnenachse (7) am Sonnensystem (9) angeordnete Übertragerringfläche (72) umfasst, an welcher ein Übertragerrad (29) am Mondsystem (19) abrollt.

6. Träger nach Anspruch 1, **dadurch gekennzeichnet, dass** die Antriebsverbindung ein am Planetensystem drehgelagertes, mit dem Sonnensystem (9) in Rolleingriff stehendes Übertragerrad (64) umfasst, welches über ein weiteres Übertragerrad (66) und einen um die Planetenachse (11) umlaufenden Übertragerring (68) mit einem Übertragerrad (29) am Mondsystem in Rolleingriff steht.

7. Träger nach Anspruch 1, **dadurch gekennzeichnet, dass** ein Planetenrad (17') eine Übertragerachse (78) treibt, welche lösbar am Sonnenrad (9) drehgelagert ist, und dass die Übertragerachse (78), über ein weiteres Übertragerrad (80) sowie einen um die Planetenachse (11) umlaufenden Ring (86), mit einem Übertragerrad (29) am Mondsystem in Rolleingriff steht.

8. Träger nach einem der Ansprüche 1 bis 6, **dadurch gekennzeichnet, dass** die Antriebsverbindung mindestens eine Sollbruchstelle (51) aufweist.

9. Träger nach einem der Ansprüche 1 bis 8, **dadurch gekennzeichnet, dass** die Sonnensystemachse (7) durch ein feststehendes Antriebsrad (88) durchgeführt ist und ein Riemenantrieb (90) sowohl das Antriebsrad (88) wie auch an den Planetenachsen vorgesehene Planetenantriebsräder (13') umschlingt.

10. Träger nach einem der Ansprüche 1 bis 9, **dadurch gekennzeichnet, dass**, betrachtet in Richtung der Sonnensystemachse (7), mehrere der Mondsysteme (31) übereinander am Planetensystem (17) vorhanden sind.

11. Träger nach einem der Ansprüche 1 bis 10, **dadurch gekennzeichnet, dass** die Antriebskopplung (15, 13) und die Antriebsverbindung unterhalb einer Bewegungsebene der Aufnahme eingebaut sind.

12. Behandlungskammer mit mindestens einem Träger nach einem der Ansprüche 1 bis 11, **dadurch gekennzeichnet, dass** Detektionsmittel, wie optoelektrische Abtaster, vorgesehen sind, um Abweichungen der Trägersystem-Bewegungen von ihrem SOLL-Verhalten zu detektieren.

13. Verfahren zur Herstellung von Werkstücken mithilfe einer Vakuumoberflächenbehandlung, bei dem die Werkstücke an einem Träger nach einem der Ansprüche 1 bis 11 in Behandlungsatmosphäre auf einer Kreisbahn um eine erste (7) Kreisbahn bewegt werden, zusätzlich entlang einer zweiten Kreisbahn, nämlich um eine zweite (11) Achse versetzt und achsparallel zur ersten (7), hinzukommend um eine dritte Achse (19), durch die Werkstücke selber, in Eigendrehbewegung versetzt werden, wobei eine Antriebsverbindung, ununterbrochen zwischen Bewegung um die erste (7) Kreisbahn und Bewegung um die dritte (19) Achse erstellt wird, und alle drei Drehbewegungen kontinuierlich erzeugt werden, und dabei die Werkstücke oberflächenbehandelt werden.

## Claims

1. Vacuum treatment planetary system workpiece support for vacuum treatment plants, comprising:
- a sun system (9, 9') which can be rotated about a sun system axis (7) in relation to the plant and coupled with a plant-side drive (1),
- at least one planetary system (17, 17'), mounted on the sun system (9, 9') to be rotational about a planetary axis (11) and fitted with a drive coupling (15, 13) in relation to the plant (3),
- at least one moon system (29, 31) mounted on the planetary system (17) to be rotational about a moon axis (19) and with a drive connection to the sun system (7, 9, 9'), on which moon system is provided a holder for at least one workpiece, where the drive connection is produced at least in operation uninterrupted between the sun system and the moon system.

2. Support according to claim 1, **characterised in that** the drive connection is a forced drive connection, preferably a toothed connection.

3. Support according to claim 1 or 2, **characterised in that** the drive connection between the moon system and the sun system comprises a transmission arrangement (21; 60, 66, 68; 76, 80, 86) which is rotatable freely about the planetary axis (11) and stands in transmission engagement with firstly the sun system (27) and secondly the moon system (29).

4. Support according to claim 1 or 2, **characterised in that** the drive connection comprises a transmission wheel (21) which is rotatable freely about the planetary axis (11) and stands in engagement with a transmission wheel (29) on the moon system and acts with a rotation stop (25) on a shoulder on the sun system (9).

5. Support according to claim 1, **characterised in that** the drive transmission comprises a transmission ring surface (72) which is arranged coaxial to the sun axis (7) on the sun system (9) and on which rolls a transmission wheel (29) on the moon system (18).

6. Support according to claim 1, **characterised in that** the drive connection comprises a transmission wheel (64) which is mounted rotationally on the planetary system and stands in rolling engagement with the sun system (9) and in rolling engagement with a transmission wheel (29) on the moon system via a further transmission wheel (66) and a transmission ring (68) surrounding the planetary axis (11).

7. Support according to claim 1, **characterised in that** a planetary wheel (17') drives a transmission axle (78) which is mounted detachably and rotationally on the sun wheel (9), and that the transmission axle (78) stands in rolling engagement with a transmission wheel (29) on the moon system via a further transmission wheel (80) and a ring (86) surrounding the planetary axis (11).

8. Support according to any of claims 1 to 6, **characterised in that** the drive connection has at least one nominal break point (51).

9. Support according to any of claims 1 to 8, **characterised in that** the sun system axis (7) extends through a fixed drive wheel (88), and a belt drive (90) surrounds both the drive wheel (88) and planetary drive wheels (13') provided on the planetary axis.

10. Support according to any of claims 1 to 9, **characterised in that** viewed in the direction of the sun system axis (7), several of the moon systems (31) are provided above one another on the planetary system (17).

11. Support according to any of claims 1 to 10, **characterised in that** the drive coupling (15, 13) and the drive connection are installed below a movement plane of the holder.

12. Processing chamber with at least one support according to any of claims 1 to 11, **characterised in that** detection means such as optoelectrical sensors are provided in order to detect deviations of the support system movements from their nominal behaviour.

13. Process for the production of workpieces by means of vacuum surface treatment, in which the workpieces on a support according to any of claims 1 to 11 are moved within a treatment atmosphere along an orbit about a first (7) orbit, additionally along a second orbit namely around a second (11) axis offset and axis-parallel to the first (7), further around a third axis (19), whereby the workpieces themselves are set in own rotation, where an uninterrupted drive connection is created between the movement about the first (7) orbit and the movement about the third (19) axis, and all three rotary movements are generated continuously, during which the workpieces are surface-treated.

## Revendications

1. Porte-pièces à système planétaire pour traitement sous vide pour des installations de traitement sous vide, comprenant :
- un système solaire (9, 9') qui est apte à être accouplé à un entraînement (1) prévu côté installation et qui est apte à tourner par rapport à l'installation autour d'un axe de système solaire (7),
- au moins un système planétaire (17, 17') qui est monté sur le système solaire (9, 9') pour pouvoir tourner autour d'un axe planétaire (11) et qui est pourvu d'un accouplement d'entraînement (15, 13) par rapport à l'installation (3),
- au moins un système lunaire (29, 31) qui est monté sur le système planétaire (17) pour pouvoir tourner autour d'un axe lunaire (19), qui est pourvu d'une liaison d'entraînement avec le système solaire (7, 9, 9') et sur lequel est prévu un logement pour au moins une pièce, la liaison d'entraînement étant réalisée sans interruption, au moins en fonctionnement, entre le système solaire et le système lunaire.

2. Porte-pièces selon la revendication 1, **caractérisé en ce que** la liaison d'entraînement est une liaison d'entraînement forcée, de préférence une liaison par engrenage.

3. Porte-pièces selon la revendication 1 ou 2, **caractérisé en ce que** la liaison d'entraînement entre le système lunaire et le système solaire comprend un dispositif de transmission (21 ; 60, 66, 68 ; 76, 80, 86) qui est apte à tourner librement autour de l'axe planétaire (11) et qui est en prise de transmission avec le système solaire (27), d'une part, et avec le système lunaire (29), d'autre part.

4. Porte-pièces selon la revendication 1 ou 2, **caractérisé en ce que** la liaison d'entraînement comporte une roue de transmission (21) apte à tourner librement autour de l'axe planétaire (11) et en prise avec une roue de transmission (29) du système lunaire, qui agit avec un arrêt de rotation (25) sur une butée du système solaire (9).

5. Porte-pièces selon la revendication 1, **caractérisé en ce que** la transmission d'entraînement comprend une surface annulaire de transmission (72) qui est coaxiale par rapport à l'axe solaire (7) du système solaire (9) et sur laquelle roule une roue de transmission (29) du système lunaire (19).

6. Porte-pièces selon la revendication 1, **caractérisé en ce que** la liaison d'entraînement comprend une roue de transmission (64) qui est montée en rotation sur le système planétaire, qui est en prise de roulement avec le système solaire (9) et qui est en prise de roulement avec une roue de transmission (29) du système lunaire par l'intermédiaire d'une autre roue de transmission (66) et d'une couronne de transmission (68) tournant autour de l'axe planétaire (11).

7. Porte-pièces selon la revendication 1, **caractérisé en ce qu'**une roue planétaire (17') entraîne un axe de transmission (78) qui est monté en rotation, de manière détachable, sur la roue solaire (9), et **en ce que** l'axe de transmission (78) est en prise de roulement avec une roue de transmission (29) du système lunaire par l'intermédiaire d'une autre roue de transmission (80) et d'une couronne (86) qui tourne autour de l'axe planétaire (11).

8. Porte-pièces selon l'une des revendications 1 à 6, **caractérisé en ce que** la liaison d'entraînement comporte au moins un point de rupture (51).

9. Porte-pièces selon l'une des revendications 1 à 8, **caractérisé en ce que** l'axe de système solaire (7) traverse une roue d'entraînement fixe (88), et une commande à courroie (90) passe à la fois sur la roue d'entraînement (88) et sur des roues d'entraînement planétaires (13') prévues sur les axes planétaires.

10. Porte-pièces selon l'une des revendications 1 à 9, **caractérisé en ce que**, dans le sens de l'axe de système solaire (7), plusieurs systèmes lunaires (31) sont superposés sur le système planétaire (17).

11. Porte-pièces selon l'une des revendications 1 à 10, **caractérisé en ce que** l'accouplement d'entraînement (15, 13) et la liaison d'entraînement sont montés au-dessous d'un plan de déplacement du logement.

12. Chambre de traitement comportant au moins un porte-pièces selon l'une des revendications 1 à 11, **caractérisée en ce qu'**il est prévu des moyens de détection tels que des détecteurs optoélectriques pour détecter les écarts des mouvements du système de porte-pièces par rapport à son comportement théorique.

13. Procédé pour fabriquer des pièces à l'aide d'un traitement de surface sous vide, selon lequel les pièces prévues sur un porte-pièces selon l'une des revendications 1 à 11 sont déplacées dans l'atmosphère de traitement sur une trajectoire circulaire autour d'un premier axe (7) et en supplément sur une deuxième trajectoire circulaire, autour d'un deuxième axe (11) décalé et parallèle au premier axe (7), et tournent encore en supplément sur elles-mêmes autour d'un troisième axe (19) qui traverse les pièces elles-mêmes, une liaison d'entraînement étant réalisée sans interruption entre le mouvement autour du premier axe (7) et le mouvement autour du troisième axe (19), les trois rotations étant produites en continu et la surface des pièces étant alors traitée.
